# EUROPEAN PATENT APPLICATION

(11) **EP 1 550 738 A1**
(43) Date of publication of application: **06.07.2005**
(21) Application number: 04257924.3
(22) Date of filing: 17.12.2004
(51) Int. Cl.: C23C 16/455

(54) **Method and apparatus for atomic layer deposition**

(30) Priority: 31.12.2003 US 750310
(71) Applicant: THE BOC GROUP, INC., Murray Hill, New Providence, New Jersey 07974 (US)
(72) Inventor: Dickinson, Colin John, San Jose California 95123 (US); Jansen, Frank, San Jose California 95132 (US)
(74) Representative: Booth, Andrew Steven

(57) **Abstract**

An atomic layer deposition process is described in which precursor gases including species used to form monatomic layers are quickly alternated as to allow the atomic layer deposition process to be conducted with fast cycle time.

## Description

This invention is directed to atomic layer deposition. More particularly this invention provides an apparatus and process in which precursor gases including the species used to form monatomic layers can be quickly alternated so as to allow the atomic layer deposition process to be conducted with fast cycle time.

Atomic layer deposition is a method of depositing very thin films onto a surface. Individual precursor gases are pulsed onto the surface, typically a wafer, in a sequential manner without mixing the precursors in the gas phase. Each precursor gas reacts with the surface to form an atomic layer in a way such that only one layer at a time can be deposited onto the surface.

In order to avoid clogging and reaction of the precursor gases in areas other than the desired surface, inert gases such as argon and nitrogen are used as purge gases between application of different precursor gases. For example, Si₂Cl₆ and NH₃, TiCl₄ and NH₃, Si₂Cl₆ and activated NH₃ are commonly used precursors.

Unfortunately, interruption of flow of a precursor gas in order to allow introduction of another precursor gas can result in condensation related problems especially when using unstable precursors.

Accordingly, there is a need for an atomic layer deposition arrangement and process which reduces condensation, avoids clogging and reaction of the precursor gases in areas other than the desired surface, minimizes gas turbulence and provides fast cycle time.

In a first aspect, the present invention provides an atomic layer deposition arrangement comprising a process chamber including an inlet for receiving precursor gases and at least one outlet coupled through an outlet line to an exhaust pump, first precursor gas valve means coupled to the inlet for receiving a first precursor gas, second precursor gas valve means coupled to the inlet for receiving a second precursor gas, a first bypass conduit coupled to said first precursor gas valve means, and a second bypass conduit coupled to said second precursor gas valve means, wherein the first bypass conduit and the second bypass conduit are isolated from the outlet line.

A preferred embodiment provides an atomic layer deposition arrangement comprising a process reactor chamber including an inlet for receiving precursor gases and at least one outlet coupled through an outlet line to an exhaust pump, a first precursor gas valve which receives a first precursor gas and second precursor gas valve which receives a second precursor gas. The first precursor gas valve and second precursor gas valve are coupled to the inlet of the process reactor chamber. A first bypass conduit coupled to the first precursor valve and a second bypass conduit coupled to the second precursor valve allows steady flow of the precursor gases in between delivery to the process reactor chamber. The first bypass conduit and second bypass conduit are isolated from the outlet line. The outlet line coupled to the exhaust pump allows fast evacuation of the process reactor chamber.

In a second aspect, the present invention provides a method for delivering precursor gas to an atomic layer deposition chamber, the method comprising introducing a substrate into a process chamber having a chamber inlet and chamber outlet, reducing pressure in the chamber, flowing a first precursor gas to an inlet of a first gas valve means in a bypass position coupling the first precursor gas to a first bypass conduit, switching the first gas valve means to a chamber delivery position coupling the first precursor gas to the chamber inlet to deliver the first precursor gas to the chamber, switching the first gas valve means to the bypass position, reducing pressure in the chamber, flowing a second precursor gas to an inlet of a second gas valve means in a bypass position coupling the second precursor gas to a second bypass conduit, switching the second gas valve means to a chamber delivery position coupling the second precursor gas to the chamber inlet to deliver the second precursor gas to the chamber, and switching the second gas valve means to the bypass position, wherein the first bypass conduit and the second bypass conduit are isolated from the outlet.

Another preferred embodiment provides a method for delivering precursor gas to an atomic layer deposition chamber comprising introducing a substrate into a process reactor chamber having a chamber inlet and a chamber outlet, reducing pressure in the chamber, flowing a first precursor gas to an inlet of a bypass position of a first gas valve, the first gas valve including a chamber delivery position coupled to the chamber inlet, switching the first gas valve to the chamber delivery position to convey the first precursor gas from the gas valve to the chamber inlet, switching the first gas valve to the inlet of the bypass position of the first gas valve, reducing pressure in the chamber, flowing a second precursor gas to the inlet of a bypass position of a second gas valve, the second gas valve including a chamber delivery position coupled to the chamber inlet, switching the second gas valve to a chamber delivery position to convey the second precursor gas from the second gas valve to the chamber inlet, and switching the second gas valve to the inlet of the bypass position of the second gas valve wherein the second precursor gas is conveyed to the chamber inlet without previously purging the chamber with a purge gas.

The present invention also provides a method for delivering precursor gas to an atomic layer deposition chamber, the method comprising placing a substrate onto a substrate holding device in a process reactor chamber having a chamber inlet and chamber outlet, isolating the chamber by closing a gate valve, reducing pressure in the chamber by moving the substrate holding device upward in a longitudinal direction to provide a high conductance connection between the chamber and the vacuum pump, isolating the chamber from the vacuum pump by moving the substrate holding device downward in a longitudinal direction to provide a minimum conductance connection between the chamber and a vacuum pump, flowing a first precursor gas to an inlet of a bypass position of a first gas valve, the first gas valve including a chamber delivery position coupled to the chamber inlet, switching said first gas valve to the chamber delivery position to convey the first precursor gas from the gas valve to the chamber inlet, switching said first gas valve to the inlet of the bypass position of the first gas valve, reducing pressure in the chamber by moving the position of the substrate holding device upward in a longitudinal direction to provide a high conductance connection between the chamber and a vacuum pump, isolating the chamber from the vacuum pump by moving the substrate holding device downward in a longitudinal direction to provide a minimum conductance connection between the chamber and a vacuum pump, flowing a second precursor gas to the inlet of a bypass position of a second gas valve, the second gas valve including a chamber delivery position coupled to the chamber inlet, switching said second gas valve to a chamber delivery position to convey the second precursor gas from the second gas valve to the chamber inlet, switching said second gas valve to the inlet of the bypass position of the second gas valve, wherein said second precursor gas is conveyed to the chamber inlet without previously purging the chamber with a full dose of purge gas.

The present invention further provides method for delivering precursor gas to an atomic layer deposition chamber, the method comprising placing a substrate onto a substrate holding device in a process reactor chamber having a chamber inlet and chamber outlet, isolating the chamber by closing a gate valve, reducing pressure in the chamber by moving the substrate holding device upward in a longitudinal direction to provide a high conductance connection between the chamber and a vacuum pump, isolating the chamber from the vacuum pump by moving the substrate holding device downward in a longitudinal direction to provide a minimum conductance connection between the chamber and the vacuum pump, flowing a first precursor gas to an inlet of a bypass position of a first gas valve, the first gas valve including a chamber delivery position coupled to the chambers inlet, switching said first gas valve to the chamber delivery position to convey the first precursor gas from the gas valve to the chamber inlet, switching said first gas valve to the inlet of the bypass position of the first gas valve, reducing the pressure in the chamber by moving the substrate holding device upward in a longitudinal direction to provide a high conductance connection between the chamber and a vacuum pump, flowing a purge gas into the chamber inlet to flush the residual said first gas from the chamber wherein the purge gas is flowed through the chamber in an amount less than a full dose of purge gas, reducing the pressure in the chamber by moving the position of the substrate holding device upward in a longitudinal direction to provide a high conductance connection between the chamber and a vacuum pump, isolating the chamber from the vacuum pump by moving the substrate holding device downward in a longitudinal direction to provide a minimum conductance connection between the chamber and a vacuum pump, flowing a second precursor gas to the inlet of a bypass of a second gas valve, the second gas valve including a chamber delivery position coupled to the chamber inlet, switching said second gas valve to a chamber delivery position to convey the second precursor gas from the second gas valve to the chamber inlet, switching said second gas valve to the inlet of the bypass position of the second gas valve, and flowing a purge gas into the chamber inlet at a pressure to flush the residual said second gas from the chamber.

Preferred features of the present invention will now be described, by way of example only, with reference to the accompanying drawings, in which:
Figure 1 is a schematic illustration of an atomic layer deposition arrangement;
Figure 2 is a schematic illustration of an atomic layer deposition arrangement including two-way valves;
Figure 3 is a partial cross-section view of a substrate receiving mechanism within the process chamber reactor;
Figure 4 is a schematic illustration of an atomic layer deposition arrangement including a purge gas system; and
Figure 5 is a schematic illustration of an atomic layer deposition arrangement including two-way valves to meter the precursor gases.

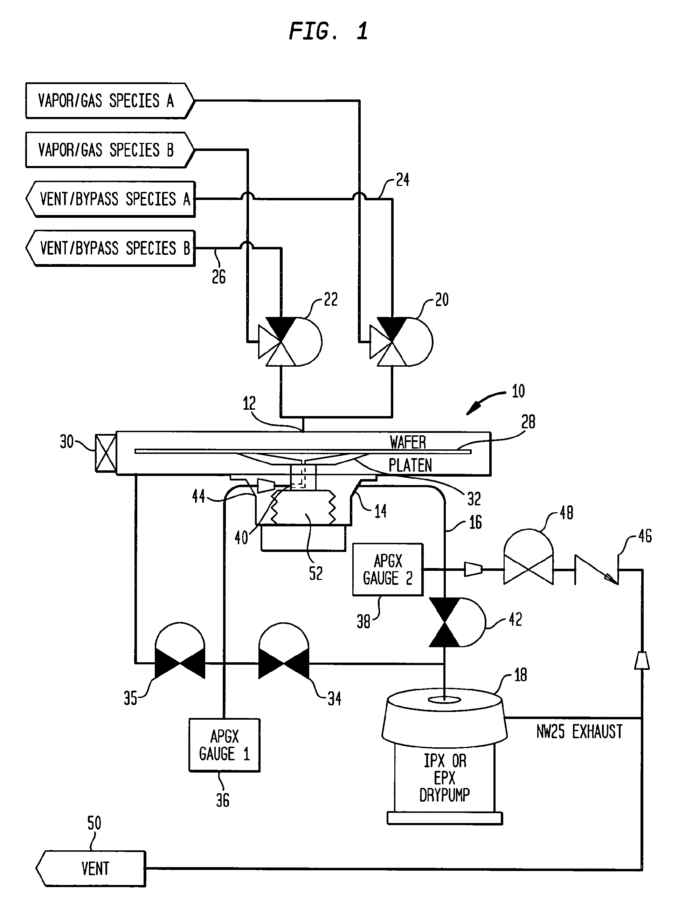

A schematic illustration of an atomic layer deposition arrangement is shown in Figure 1. The atomic layer deposition system includes a process reactor chamber 10 including an inlet 12 for receiving precursor gases. A process reactor chamber outlet 14 is coupled through an outlet line 16 to an exhaust pump 18. The exhaust pump may be any suitably sized vacuum pump, such as the EPX 180L Dry Pump available from BOC Edwards. A first precursor gas valve 20 receives a first precursor gas A and a second precursor valve 22 receives a second precursor gas B. A first bypass conduit 24 is coupled to first precursor valve 20 and a second bypass conduit 26 is coupled to second precursor valve 22. As can be seen from Figure 1, first bypass conduit 24 and second bypass conduit 26 are isolated from outlet line 16.

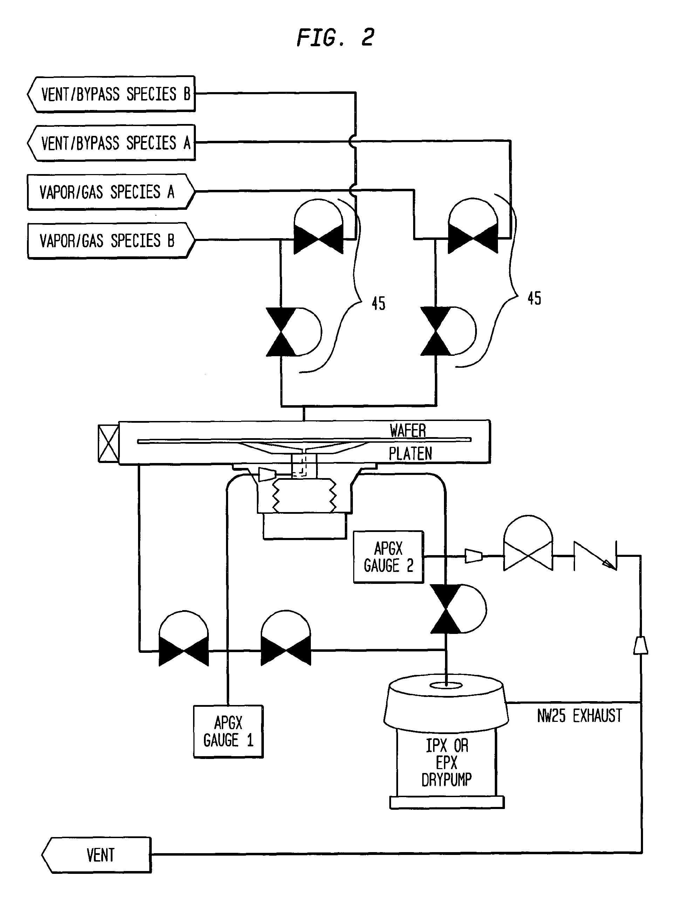

In an alternate embodiment, two sets of two way valves 45 can be used instead of a three way valve as shown in Figure 2.

In a typical atomic layer deposition process, a substrate is introduced into the process reactor chamber 10 through an opening, which is selectively closed through gate valve 30. The substrate may be for example, a processed semiconductor wafer, an unprocessed semiconductor wafer or a substrate intended for a flat panel display and/or any other type of substrate. A vacuum hold down is applied to the platen 32 by opening vacuum valve 34. The exhaust pump 18 is in flow communication with the chamber 10. Vacuum valves 34, 35 are arranged in direct communication with the chamber 10 and a vacuum hold down system 40. The vacuum hold down system 40 is configured to hold the substrate onto platen 32 during movement of the platen 32. Vacuum valve 42 may be in flow communication with the chamber 10 through the sub-chamber 44. A plurality of vacuum gauges 36, 38 may be provided to monitor the rate of evacuation of the chamber 10 through the vacuum valves 34, 35 and 42.

A check valve 46 may be associated with the gas flow path downstream from exhaust valve 48 to prevent back flow of gas while the exhaust valve 48 is open in the event the chamber 10 is under pressurized. The vacuum pump 18 is connected to a vent 50.

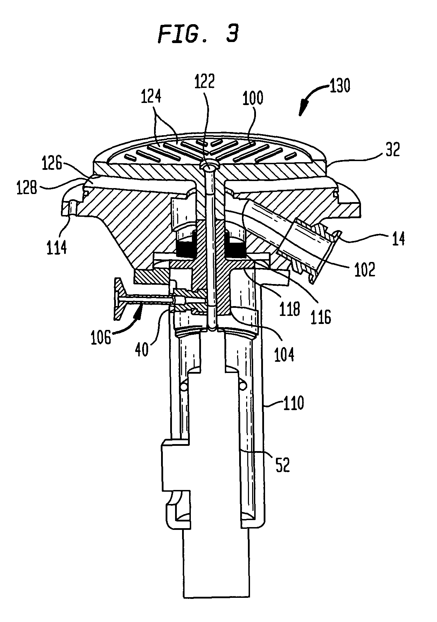

A more detailed view of the platen 32 is shown in Figure 3. The platen 32 is attached to a movement mechanism 52 which may be a linear actuator, a hydraulic piston, a pneumatic piston, or any other mechanism suitable for linear motion to the platen 32.

The platen 32 has at least one through hole 100 formed therein. The platen 32 also has a first hollow shaft portion 102 and a second hollow shaft portion 104 in flow communication with the through hole 100 in the platen. A port member 106 is inserted into vacuum outlet 40, which is in flow communication with the hollow shaft portion 102. The other end of the port member 106 is in flow communication with the vacuum pump 18, shown in Figure 1. The structure 122 forming a flow path placing the through hole 100 in flow communication with the vacuum pump 18 forms a vacuum hold down that secures the object to the surface of the platen 32. A plurality of raised portions 124 assist in distributing vacuum force to the surface of the platen and thereby aid in securing an object to the platen 32.

The end of the hollow shaft portion 102 opposite the platen 32 is attached to a movement mechanism 52 which may be a linear actuator, a hydraulic piston, a pneumatic piston, or any other mechanism suitable for providing linear motion to the platen 32.

The movement mechanism 52 is arranged within a support member 110 affixed to the sub-chamber 44. The sub-chamber 44 may be fastened to the chamber 10 of Figure 1 via one or more through holes 114 (only one of which is shown). This arrangement allows the platen 32 to be raised and lowered in relation to the sub-chamber 44 and the interior of the chamber 10. A steel bellows 116 is also contained within the sub-chamber 44 to cooperate with a radically extending flange portion 118 on the hollow shaft portion 102 to seal the sub-chamber 44 around the hollow shaft portion 104.

The sub-chamber 44 includes an outlet 14 (e.g., exhaust port) that provides flow communication between the interior of the chamber 10 of Figure 1 and vacuum pump 18. The outlet 14 and outlet line 16 define an exhaust flow path that may be connected to both the vacuum pump 18 and the exhaust valve 48, shown in Figure 1, to provide vacuum flow in the exhaust flow path.

The platen 32 is arranged above the outlet 14 and is movable in the interior of the chamber 10 so as to adjust conductance of the exhaust flow from the interior of the chamber 10 to the exhaust flow path via the outlet 14. For example, the platen 32 can be raised and lowered to vary the distance H between a lower surface 126 of the platen and the upper surface 128 of the sub-chamber 44. Varying the distance H controls the rate at which gas is withdrawn from the chamber 10 during placement of the chamber into vacuum condition and varies the conductance between the platen 32 and the sub-chamber 44 through the outlet 14. This object receiving mechanism 130 is configured to increase throttling of gas being withdrawn when the object receiving mechanism 130 is in a lowered position and to decrease the throttling when the object receiving mechanism 130 is in a raised positioned. This may prevent damage to the object 28 during the gas evacuation process. In addition, by raising the object receiving mechanism 130, the conductance is increased and by lowering the object receiving mechanism 130, the conductance is decreased.

By monitoring the vacuum gauges 36, 38, shown in Figure 1, it is possible to control the movement mechanism 52 to vary the distance H and thereby adjust the flow rate of withdrawn gas. Alternatively, without relying on the vacuum gages 36, 38, the positioning and movement of the platen 32 over a period of time could be predetermined to adjust the flow rate accordingly. Both approaches may be accomplished by configuring a controller, not shown, to control the movement of the object receiving mechanism 130 to adjust the throttling of the exhaust flow from the interior of the chamber 10 based on the position of the object receiving mechanism 130 or data from the vacuum gages 36, 38. In this manner platen position can be adjusted to provide necessary conductance for the chamber to be evacuated in a suitable time frame without causing particle stirring within the chamber.

During the chamber evacuation valves 20 and 22 are in bypass mode so that steady gas conditions are achieved for precursor gas species A and B.

Once an appropriate reduced pressure is achieved, the movement mechanism 52 is moved downwards to create minimum conductance to the vacuum pump 18. The 3 way valve 20 is then switched to allow flow of vapor/gas species A to the chamber 10 to deposit a monatomic layer onto the substrate. During this process the chamber pressure will rise to around atmospheric pressure. The valve 20 is then switched to bypass and the movement mechanism 52 moves upward to allow evacuation of the chamber 10 to remove vapor/gas species A. After a reduced pressure is obtained, the movement mechanism 52 moves downward to provide the minimum conductance to the vacuum pump and valve 22 is switched to allow flow of vapor/gas species B to the chamber 10 to deposit a monatomic layer onto the substrate.

The above process is repeated to provide sequential deposition of a plurality of layers of A and B until the desired deposition thickness is achieved. Each species/layer can be deposited in a 1-2 second cycle time.

On completion of the deposition process isolation valve 48 is opened, valve 42 is closed and valve 35 is opened to allow the wafer vacuum hold down to be released. The gate valve 30 is then opened to allow the substrate to be removed from the chamber.

The process chamber 10 may be connected to a conventional vacuum cluster central handler or alternatively connected to an atmospheric robot handling system. This allows atomic layer deposition processes to be integrated to any configuration of wafer processing architecture.

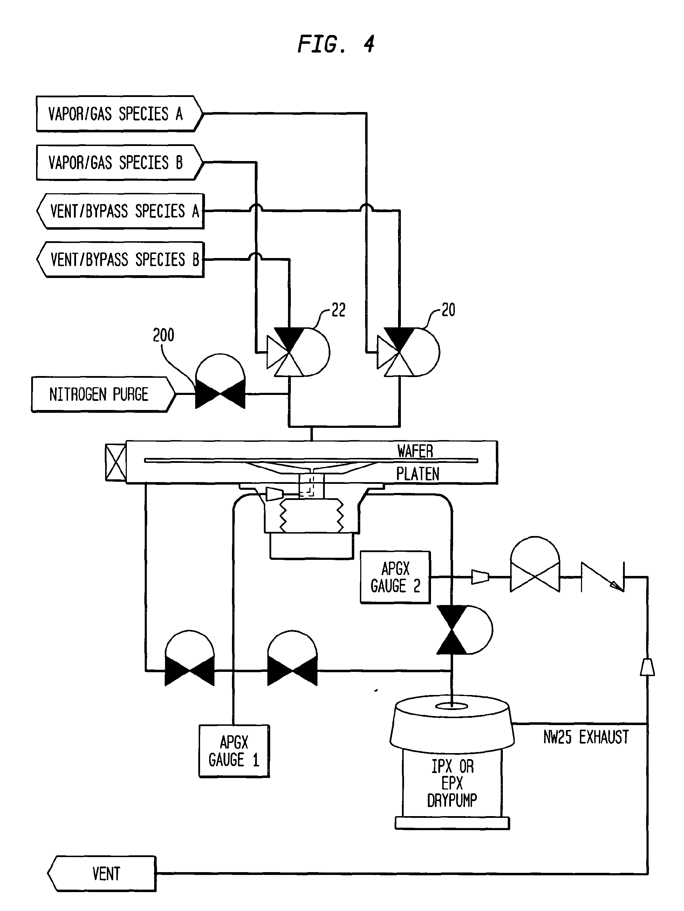

An alternate embodiment including a purge gas system is shown in Figure 4. In between introduction of precursor gas A and precursor gas B to the process reactor, a purge gas, for example, nitrogen or argon, is introduced into the process reactor chamber 10. Each of valve 20 and 22 are in bypass mode as the purge gas flows into process chamber 10 through valve 200. The purge gas flows through process reactor chamber 10 to the vacuum pump. Preferably, the purge gas is introduced into process reactor chamber 10 at a pressure of 5 standard (std) liters per minute for less than 5 seconds duration, more preferably 1 standard (std) liter per minute for less than 2 seconds duration. Unlike conventional systems, in which a full dose of purge gas is introduced into the process chamber at a pressure of 10 std liters per minute for 5 to 10 seconds, the purge process is substantially reduced. In this manner, the invention provides for fast cycle times.

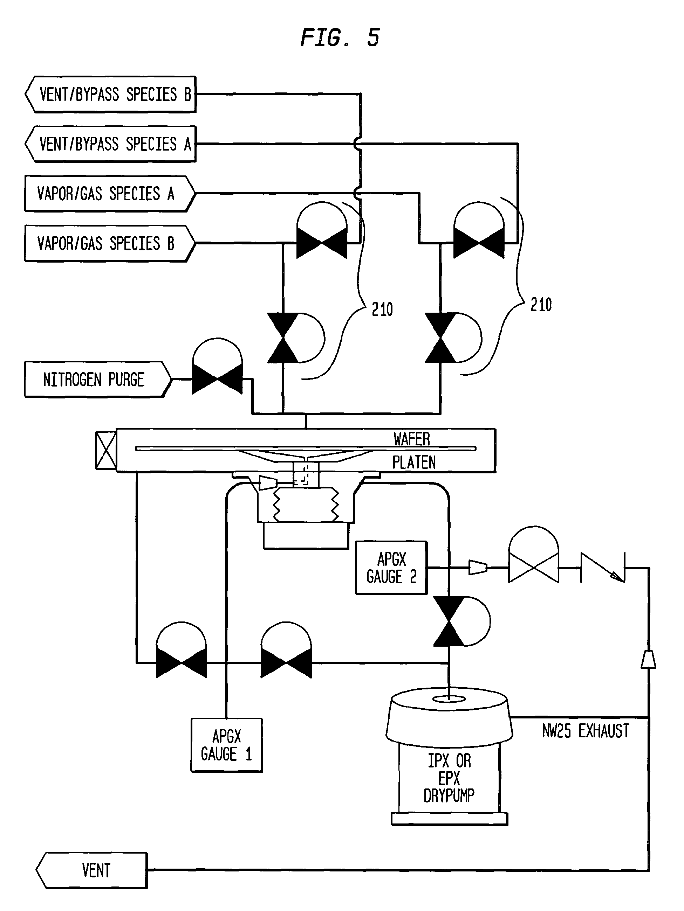

An embodiment including a purge gas system wherein the precursor gases are metered using two way valves is shown in Figure 5. The two sets of two way valves 210 and 220 control the flow of precursor gas A and precursor gas B.

In summary, an atomic layer deposition process is described in which precursor gases including species used to form monatomic layers are quickly alternated as to allow the atomic layer deposition process to be conducted with fast cycle time.

Although preferred embodiments are specifically illustrated and described herein above, it will be appreciated that many modifications and variations of the present invention are possible in light of the above teachings and within the preview of the appended claims without departing from the scope of the invention.

## Claims

1. An atomic layer deposition arrangement comprising a process chamber including an inlet for receiving precursor gases and at least one outlet coupled through an outlet line to an exhaust pump, first precursor gas valve means coupled to the inlet for receiving a first precursor gas, second precursor gas valve means coupled to the inlet for receiving a second precursor gas, a first bypass conduit coupled to said first precursor gas valve means, and a second bypass conduit coupled to said second precursor gas valve means, wherein the first bypass conduit and the second bypass conduit are isolated from the outlet line.

2. An atomic layer deposition arrangement according to Claim 1, wherein the first precursor gas valve means and second precursor gas valve means are each a three way valve.

3. An atomic layer deposition arrangement according to Claim 1, wherein the first precursor gas valve means and second precursor gas valve means each include two two-way valves.

4. An atomic layer deposition arrangement according to any preceding claim, wherein the first bypass conduit and the second bypass conduit are isolated from each other.

5. An atomic layer deposition arrangement according to any preceding claim, further comprising a substrate holding device located in the process chamber, the substrate holding device being movable in a longitudinal direction.

6. An atomic layer deposition arrangement according to Claim 5, wherein the substrate holding device comprises a vacuum hold down system.

7. An atomic layer deposition arrangement according to Claim 6, wherein the vacuum hold down system includes a hollow shaft connected to a plate member having at least one through hole.

8. An atomic layer deposition arrangement according to any preceding claim, further comprising a valve for receiving a purge gas, said valve being coupled to the inlet to the process chamber.

9. An atomic layer deposition arrangement according to any preceding claim, wherein the process chamber includes a sub-chamber and wherein the at least one outlet is located in the sub-chamber.

10. A method for delivering precursor gas to an atomic layer deposition chamber, the method comprising introducing a substrate into a process chamber having a chamber inlet and chamber outlet, reducing pressure in the chamber, flowing a first precursor gas to an inlet of a first gas valve means in a bypass position coupling the first precursor gas to a first bypass conduit, switching the first gas valve means to a chamber delivery position coupling the first precursor gas to the chamber inlet to deliver the first precursor gas to the chamber, switching the first gas valve means to the bypass position, reducing pressure in the chamber, flowing a second precursor gas to an inlet of a second gas valve means in a bypass position coupling the second precursor gas to a second bypass conduit, switching the second gas valve means to a chamber delivery position coupling the second precursor gas to the chamber inlet to deliver the second precursor gas to the chamber, and switching the second gas valve means to the bypass position, wherein the first bypass conduit and the second bypass conduit are isolated from the outlet.

11. A method according to Claim 10, wherein the first precursor gas valve means and second precursor gas valve means are each a three way valve.

12. A method according to Claim 10, wherein the first precursor gas valve means and second precursor gas valve means each include two two-way valves.

13. A method according to any of Claims 10 to 12, wherein the first precursor gas is selected from the group consisting of Si₂Cl₆ and TiCl₄.

14. A method according to any of Claims 10 to 13, wherein the second precursor gas is selected from the group consisting of NH₃ and activated NH₃.

15. A method according to any of Claims 10 to 14, wherein the pressure in the chamber is reduced by moving a substrate holding device upward in a longitudinal direction to provide a high conductance connection between the chamber and a vacuum pump, and the chamber is subsequently isolated from the vacuum pump by isolating the chamber from the vacuum pump by moving the substrate holding device downward in a longitudinal direction to provide a minimum conductance connection between the chamber and the vacuum pump.

16. A method according to any of Claims 10 to 15, wherein the second precursor gas is delivered to the chamber without previously purging the chamber with a full dose of purge gas.

17. A method according to any of Claims 10 to 16, wherein, between the delivery of the first and second precursor gases, the pressure in the chamber is reduced, and the purge gas is delivered to the chamber inlet to flush residual first gas from the chamber.

18. A method according to Claim 17, wherein the purge gas is delivered to the chamber inlet at a flow rate up to 5 standard liter per minute for less than 5 seconds.

19. A method according to Claim 17, wherein the purge gas is delivered to the chamber inlet at a flow rate up to 1 standard liter per minute for less than 2 seconds.

20. A method according to any of Claims 17 to 19, wherein the purge gas is selected from the group consisting of nitrogen and argon.

21. A method according to any of Claims 10 to 15, wherein the second precursor gas is delivered to the chamber without previously purging the chamber with a purge gas.
